# EUROPEAN PATENT APPLICATION

(11) **EP 4 175 171 A1**
(43) Date of publication of application: **03.05.2023**
(21) Application number: 21833582.6
(22) Date of filing: 25.06.2021
(51) Int. Cl.: H03H 9/17, H03H 9/02, H03H 3/02, H03H 9/54

(54) **BULK ACOUSTIC WAVE RESONATOR AND MANUFACTURING METHOD THEREFOR, FILTER AND ELECTRONIC DEVICE**

(30) Priority: 30.06.2020 CN 202010621180
(71) Applicant: Rofs Microsystem (Tianjin) Co., Ltd, Tianjin 300462 (CN)
(72) Inventor: PANG, Wei, Tianjin 300072 (CN); HAO, Long, Tianjin 300072 (CN); XU, Yang, Tianjin 300462 (CN); MA, Xiaodan, Tianjin 300072 (CN); HUANG, Yuanqing, Tianjin 300462 (CN); YANG, Qingrui, Tianjin 300072 (CN)
(74) Representative: Ström & Gulliksson AB
(86) International application number: PCT/CN2021/102307
(87) International publication number: WO 2022/001860

(57) **Abstract**

The present disclosure relates to a bulk acoustic wave resonator including a substrate, an acoustic mirror, a bottom electrode, a top electrode and a piezoelectric layer, wherein an overlapped area of the acoustic mirror, the bottom electrode, the piezoelectric layer and the top electrode in the thickness direction of the resonator forms an effective area of the resonator. A conductive layer is also arranged on the upper side of the top electrode and surrounding the edge of the effective area, and is electrically connected to the top electrode. A gap is provided between at least a portion of the bottom surface of the inner end and/or the outer end of the conductive layer and the upper surface of the top electrode to form a suspension structure. The present disclosure also relates to a method for manufacturing the bulk acoustic wave resonator, a filter, and an electronic device.

## Description

### TECHNICAL FIELD

Embodiments of the present disclosure relate to the field of semiconductors, and in particular, to a bulk acoustic wave resonator and a manufacturing method thereof, a filter having the resonator, and an electronic device.

### BACKGROUND

With the rapid development of the current wireless communication technologies, the application of miniaturized portable terminal devices has become increasingly widespread, and thus the demand for high-performance and small radio frequency front-end modules and devices is increased. In recent years, the filter devices such as a filter and a duplexer that include a film bulk acoustic resonator (referred to as FBAR), are increasingly popular in the market. This is because, on one hand, such filter devices have excellent electrical properties, such as low insertion loss, steep transition characteristics, high selectivity, high power capacity, and strong anti-static discharge (ESD) capability, and on the other hand, have the features of small volume and easy integration.

However, as the frequency of the resonator increases, the thicknesses of the top electrode and the bottom electrode of the resonator gradually decrease, resulting in greater connection loss of the electrodes. That is, the resistance of the electrodes increases. The increase in the resistance of the electrodes may lead to decrease in the Q value of the resonator.

### SUMMARY

The present disclosure is provided to improve the Q value of a resonator in the case where a thickness of a top electrode of the resonator is relatively thin.

According to one aspect of embodiments of the present disclosure, a bulk acoustic wave resonator is provided. The bulk acoustic wave resonator includes a substrate, an acoustic mirror, a bottom electrode, a top electrode, and a piezoelectric layer. The acoustic mirror, the bottom electrode, the piezoelectric layer and the top electrode overlap with each other in a thickness direction of the resonator to form an overlapping region, and the overlapping region is an effective region of the resonator. A conductive layer is provided on an upper side of the top electrode and surrounds an edge of the effective region, and the conductive layer is electrically connected to the top electrode. A bottom surface of at least part of an inner end and/or an outer end of the conductive layer is spaced apart from an upper surface of the top electrode by a gap, and the gap forms a suspended structure.

The embodiments of the present disclosure further relate to a method of manufacturing a bulk acoustic wave resonator. The method includes forming a stacked structure of a bottom electrode, a piezoelectric layer, and a top electrode material layer on a substrate. The method further includes: step 1, forming and patterning a sacrificial layer on the stacked structure; step 2, forming a conductive material layer that covers the patterned sacrificial layer and the top electrode material layer, the conductive material layer being electrically connected to the top electrode material layer; step 3, providing and patterning a barrier layer on the conductive material layer, an inner end of the patterned barrier layer being located on an inner side of a corresponding outer end of the sacrificial layer in a lateral direction of the resonator; step 4, removing a portion of the conductive material layer that is not covered by the patterned barrier layer and removing the top electrode material layer, to form a conductive layer and a top electrode; and step 5, releasing the sacrificial layer to form a gap between a bottom surface of an inner end of the conductive layer and an upper surface of the top electrode, to form an inner end suspended structure. The resonator includes an acoustic mirror, an overlapping region of the acoustic mirror, the top electrode, the piezoelectric layer and the bottom electrode in a thickness direction of the resonator forms an effective region of the resonator, and in step 4, the conductive layer is disposed around an edge of the effective region.

The embodiments of the present disclosure further relate to a filter including the bulk acoustic wave resonator described above.

The embodiments of the present disclosure further relate to an electronic device including the filter or the resonator described above.

### BRIEF DESCRIPTION OF DRAWINGS

The following description and drawings may help understand these and other features and advantages in various embodiments of the present disclosure. The same reference signs in the drawings always indicate the same components.
FIG. 1A is a schematic top view of a bulk acoustic wave resonator in the related art.
FIG. 1B is a schematic top view of a bulk acoustic wave resonator according to an exemplary embodiment of the present disclosure.
FIG. 2 is an exemplary sectional view along line A-A' in FIG. 1A.
FIG. 3 is an exemplary sectional view along line B-B' in FIG. 1B.
FIG. 4 is a schematic sectional view of a bulk acoustic wave resonator in the related art, in which a top electrode is provided with a bridge structure and a wing.
FIG. 5 is a schematic sectional view of a bulk acoustic wave resonator according to an exemplary embodiment of the present disclosure, in which a top electrode is provided with a bridge structure and a wing, and a conductive layer is provided on the top electrode.
FIG. 6A and FIG. 6B are schematic enlarged views of a connection edge and a non-connection edge of the top electrode in FIG. 5, respectively.
FIGS. 7-12 exemplarily illustrate a process of manufacturing the bulk acoustic wave resonator shown in FIG. 5.
FIGS. 13-30 illustrate structures of bulk acoustic wave resonators according to variant embodiments of the present disclosure, respectively.
FIGS. 31-33 are exemplary sectional views of different embodiments similar to the bulk acoustic wave resonator along line B-B' in FIG. 1B.
FIGS. 34-37 exemplarily illustrate a process of manufacturing the bulk acoustic wave resonator shown in FIG. 33.

### DESCRIPTION OF EMBODIMENTS

The technical solutions of the present disclosure will be further described in detail below through embodiments and in conjunction with the drawings. The following description of the embodiments of the present disclosure with reference to the drawings is intended to explain the general inventive concept of the present disclosure, and should not be construed as limitation to the present disclosure.

First of all, the reference signs in the drawings of the present disclosure are exemplarily described as follows:
101: a substrate, which may be made of a material such as monocrystalline silicon, gallium nitride, gallium arsenide, sapphire, quartz, silicon carbide, or diamond, and may be a monocrystalline piezoelectric substrate such as lithium niobate, lithium tantalate, and potassium niobate.
102: a bottom electrode (an electrode pin or an electrode connection edge), which may be made of molybdenum, ruthenium, gold, aluminum, magnesium, tungsten, copper, titanium, iridium, osmium or chromium, or a compound or an alloy thereof.
103: an acoustic mirror, which may be a cavity, or may be a Bragg reflection layer or other equivalent forms.
104: a piezoelectric layer, which may be made of a monocrystalline piezoelectric material, and optionally, such as monocrystalline aluminum nitride, monocrystalline gallium nitride, monocrystalline lithium niobate, monocrystalline lead zirconate titanate (PZT), monocrystalline potassium niobate, monocrystalline quartz thin film, or monocrystalline lithium tantalate. In an embodiment, the piezoelectric layer may be made of a polycrystalline piezoelectric material that is a non-monocrystalline material with respect to the monocrystalline material, and optionally, such as polycrystalline aluminum nitride, zinc oxide, and PTZ. In another embodiment, the piezoelectric layer may contain rare earth element doped materials with a certain atomic ratio of the above materials, for example, may be doped aluminum nitride containing at least one rare earth element, such as scandium (Sc), yttrium (Y), magnesium (Mg), titanium (Ti), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu).
105: a top electrode (an electrode pin or an electrode connection edge), the material of which may be the same as that of the bottom electrode, and may be selected from molybdenum, ruthenium, gold, aluminum, magnesium, tungsten, copper, titanium, iridium, osmium, chromium, or a compound or an alloy thereof. The materials of the top electrode and the bottom electrode are generally the same, but may be different from each other.
106: a conductive layer, which may be made of molybdenum, ruthenium, gold, aluminum, magnesium, tungsten, copper, titanium, iridium, osmium, chromium, or a compound or an alloy thereof.
107: a surface dielectric layer of the top electrode, which may be made of AlN, SiN, SiO₂, or Al₂O₃.
108: an air gap provided above the piezoelectric layer.
109: a protruding layer provided above the piezoelectric layer, which may be made of molybdenum, ruthenium, gold, aluminum, magnesium, tungsten, copper, titanium, iridium, osmium, chromium, or a compound or an alloy thereof.
110: a sacrificial layer, which may be made of a material such as SiO₂, doped silicon dioxide, polysilicon, or amorphous silicon.
111: a surface dielectric layer of the conductive layer, which may be made of AlN, SiN, SiO₂, or Al₂O₃.
112 and 112A: sacrificial layers of the conductive layer, which may be made of materials such as SiO₂, doped silicon dioxide, polysilicon, and amorphous silicon.

In the present disclosure, a suitable edge structure while is formed while increasing the thickness of the top electrode, such that the connection loss of the top electrode is reduced. That is, the connection resistance of the top electrode is reduced, and meanwhile a Q value of the resonator is improved.

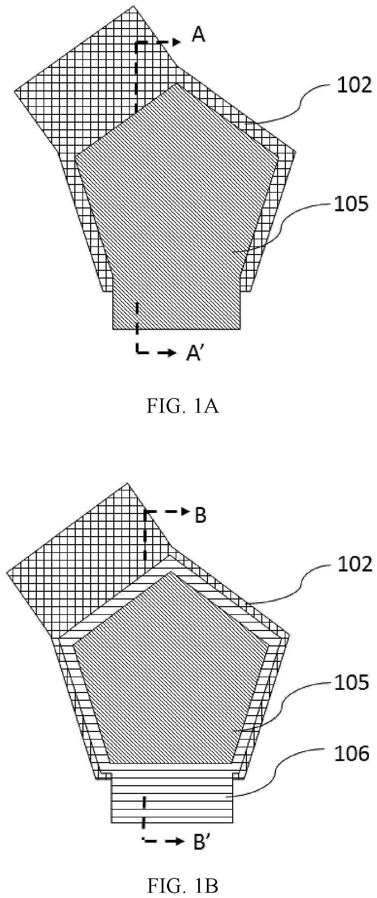

Fig. 1A shows a top view of a common resonator structure, and Fig. 1B is a top view of a bulk acoustic wave resonator according to an exemplary embodiment of the present disclosure. In Fig. 1B, a conductive layer 106 is added to the top electrode of the common resonator, and the conductive layer 106 is arranged only in an edge region of a top electrode connection edge and a non-connection edge of the top electrode.

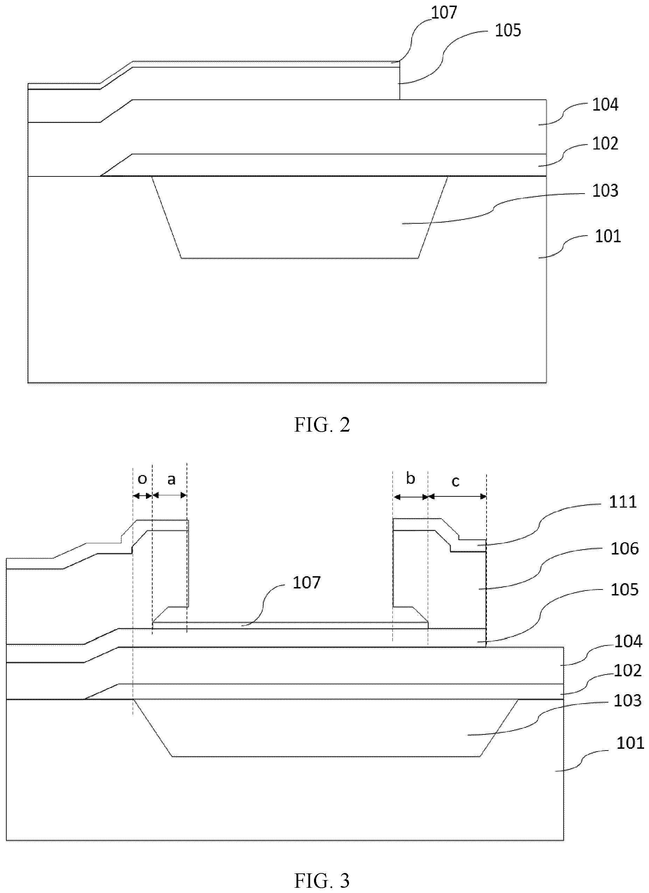

A sectional view of the resonator in FIG. 1A is obtained along a direction AA' in FIG. 1A, as shown in FIG. 2. A sandwich structure of the common resonator is shown in FIG. 2, and the common resonator includes a substrate 101, a bottom electrode 102, an acoustic mirror 103, a piezoelectric layer 104, a top electrode 105, and a surface dielectric layer 107 of the top electrode. As can be understood by those skilled in the art, the dielectric layer 107 may not be provided.

A sectional view of the resonator in FIG. 1B is obtained along a direction BB' in FIG. 1B, as shown in FIG. 3. In FIG. 3, as compared with the common resonator shown in FIG. 2, a conducive layer 106 and a surface dielectric layer 111 of the conductive layer are additionally provided. In FIG. 2 and FIG. 3, an overlapping region of the acoustic mirror, the bottom electrode, the piezoelectric layer and the top electrode in a thickness direction of the resonator forms an effective region of the resonator. In FIG. 3, the sizes indicated by a and b are width sizes of suspended portions of the conductive layer 106, in which a denotes the width size of the suspended portion at the connection edge of the top electrode, and b is the width size of the suspended portion at the non-connection edge of the top electrode. The values of a and b affect the Q value of the resonator, are related to a specific stacking thickness of the resonator, and are both greater than the Q value of the common resonator. In this case, at the non-connection edge of the top electrode, a contact portion of the conductive layer 106 with the top electrode 105, i.e., a section corresponding to a distance c in FIG. 3, has a different stacked structure from a stacked structure on the inner side of the resonator, thereby generating an acoustic impedance mismatch interface. This is beneficial for lateral acoustic waves to be reflected back into the resonator on this interface, thereby improving the Q value. Meanwhile, this contact portion of the conductive layer increases the thickness of a part of the top electrode, thereby facilitating to reduce the overall resistance of the top electrode. On the other hand, the suspended portion of the conductive layer 106 that is a section corresponding to a distance b in FIG. 3 is equivalent to a cantilever beam structure. The cantilever beam structure can generate resonance under excitation of the acoustic waves in the section corresponding to the distance c, such that a part of acoustic wave energy leaked to the section c is restrained in the suspended structure. Accordingly, the acoustic wave energy propagating from the section c to the outside of the resonator is further reduced, thereby further improving the Q value. The conductive layer 106 is divided into three portions at the connection edge of the top electrode. A portion of the conductive layer 106 completely covers an extension region of the top electrode on an outer side of the cavity, such that the resistance of the top electrode is reduced by increasing the thickness of the top electrode. Another portion of the conductive layer 106, i.e., a section corresponding to a distance o in FIG. 3, is in contact with an edge of the top electrode on an inner side of the cavity, and functions as the section corresponding to the distance c. Further, the other portion of the conductive layer 106, i.e., a section corresponding to the distance a in FIG. 3, is a suspended structure, and functions as the section corresponding to the distance b.

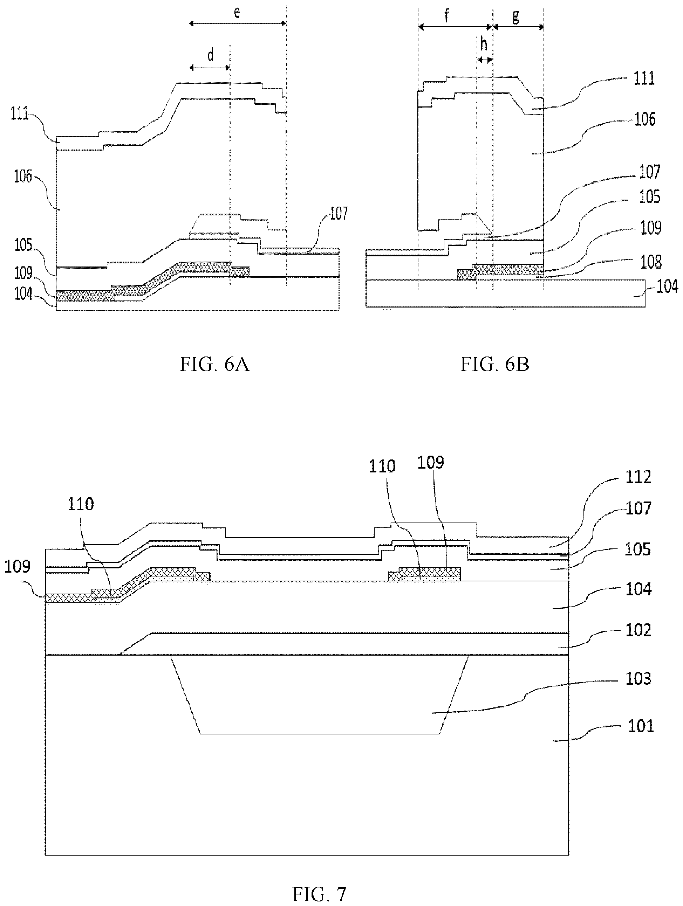

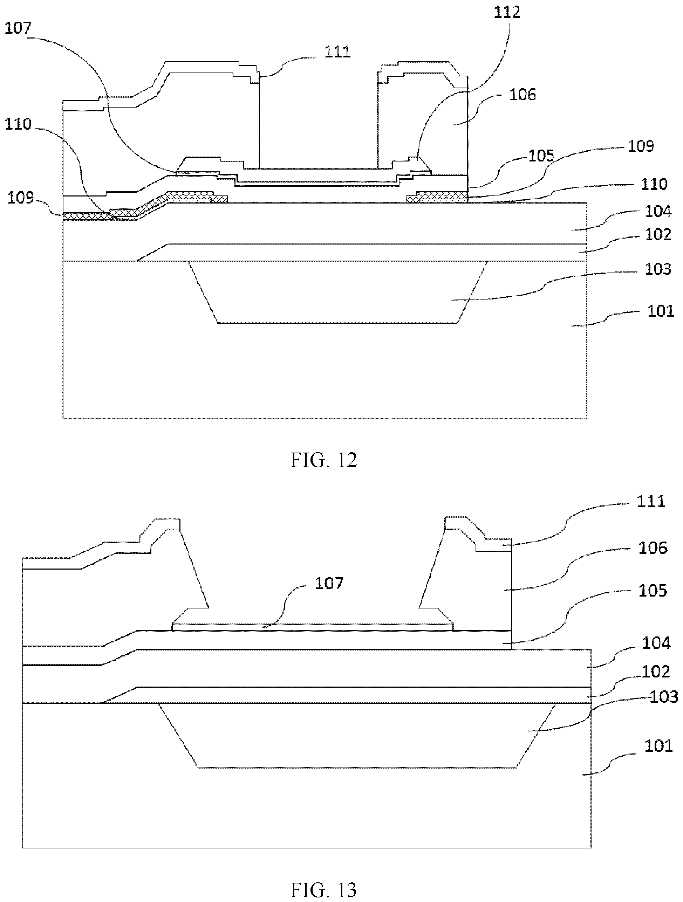

In addition, as described below with reference to FIGS. 7-12, when the conductive layer 106 and the top electrode 105 are etched in the same process, the etching of the conductive layer and the top electrode is not a two-step separate etching process. In this way, the etching cannot stop at the top electrode 105. If the size of a or b is too small, signals cannot be transmitted in the case that the top electrode is broken due to deviation of photoetching alignment during etching on the top electrode. Accordingly, this may affect the performance of the resonator. For example, as shown in FIG. 12, the etching at a portion above the resonator where there is no photoresist protection during the etching stops at the sacrificial layer 112, and the etching on the remaining portions stops at the piezoelectric layer 104. If there is alignment offset during the photolithography alignment, an opening is formed above the resonator and spans the edge of the sacrificial layer 112. In this way, the top electrode is etched through openings that are formed beyond the sacrificial layer 112, resulting in failure of the resonator. The values of a and b should not be too large. If the values of a and b are too large, the suspended portions of the conductive layer 106 may collapse. In addition, the excessive values of a and b may affect subsequent frequency adjustment. Concerning the above, in an embodiment of the present disclosure, the values of a and b are in a range of 0.2 µm to 20 µm.

As shown in FIG. 3, c indicates a contact width between the conductive layer and the top electrode at the non-connection edge of the top electrode. The value of c should not be too small. If the value of c is too small, the contact area of the conductive layer 106 and the top electrode 105 at the non-connection edge of the top electrode is small such that the conductive effect is poor. The value of c should not be too large. If the value of c is too large, the area occupied by the resonator increases. In addition, the increase in the value of c is equivalent to increase in parallel capacitance between the top electrode and the bottom electrode, such that an electromechanical coupling coefficient of the resonator becomes smaller. In an alternative embodiment of the present disclosure, the value of c is in a range of 0.2 µm to 10 µm.

In FIG. 3, the value of o is a lateral distance from an edge of the acoustic mirror 103 to a starting position of the suspended portion of the conductive layer 106 at the connection edge of the top electrode. In an embodiment of the present disclosure, the value of o is in the range of 0.2 µm to 10 µm.

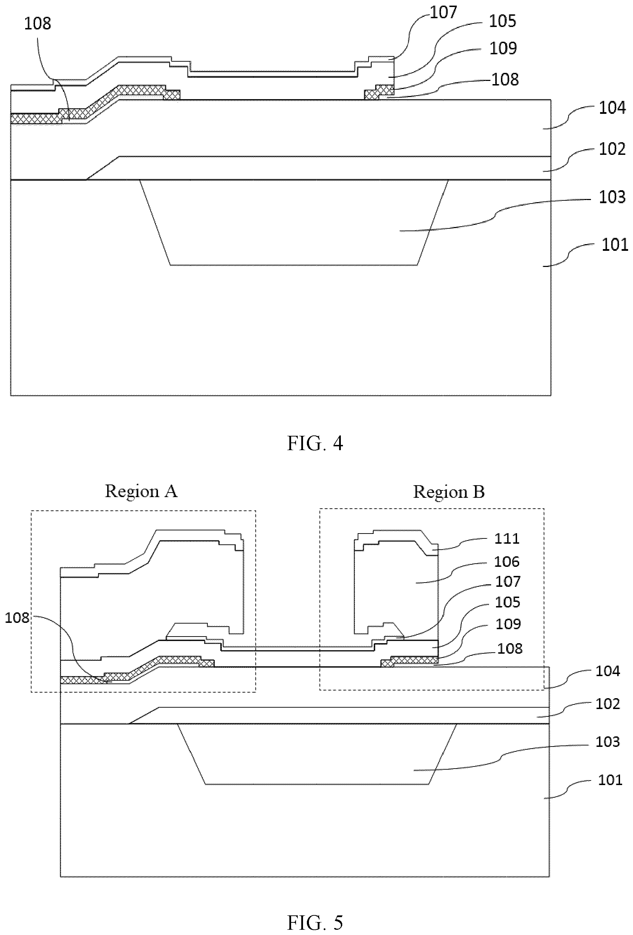

FIG. 4 is a schematic sectional view of a bulk acoustic wave resonator in the related art, in which the top electrode is provided with a bridge structure and a wing. FIG. 4 shows a sandwich structure of a common resonator in which the resonator includes an air gap 108 provided above the piezoelectric layer and a protruding layer 109 provided above the piezoelectric layer. The common resonator includes a substrate 101, a bottom electrode 102, an acoustic mirror 103, a piezoelectric layer 104, a top electrode 105, a surface dielectric layer 107 of the top electrode, the air gap 108 located above the piezoelectric layer, and the protruding layer 109 located above the piezoelectric layer. In FIG. 4, the air gap is provided such that the bridge structure and the wing of the top electrode are formed. Compared with FIG. 2 and FIG. 3, inner edges of the bridge structure and the wing in FIG. 4 further define a boundary of the effective region. That is, the inner edges of the bridge structure and the wing are located on the inner side of the effective region shown in FIGS. 2 and 3. In other embodiments in which a bridge structure and/or a wing is provided, the boundary of the effective region is configued in the same way.

FIG. 5 is a schematic sectional view of a bulk acoustic wave resonator according to an exemplary embodiment of the present disclosure, in which the top electrode is provided with a bridge structure and a wing, and a conductive layer 106 and a surface dielectric layer 111 of the conductive layer are provided on the top electrode.

The left and right sides of FIG. 5 are divided into a region A corresponding to a connection edge region and a region B corresponding to a non-connection edge region, and the region A and the region B are partially enlarged to obtain FIG .6A and FIG. 6B. In FIG .6A and FIG. 6B, the sizes of d corresponding to the connection edge of electrodes and h corresponding to the non-connection edge of electrodes are lateral distances from the connection edge of the top electrode and the conductive layer or an outer edge of the suspended structure to an inner edge of the air gap located above the piezoelectric layer, and the distances are greater than or equal to zero. In order to avoid the collapse of the suspended structure, the values of d and h cannot be too large. In an alternative embodiment, the values of d and h are in the range of 0.2 µm to 10 µm. As can be understood, d and h may be the same or different from each other.

In FIG. 6A, a size of e is a width size of a suspended portion of the conductive layer 106. Similar to a and b in FIG. 3, the size of e may be in the range of 0.2 µm to 20 µm. In FIG. 6B, a size of f is a lateral size of the suspended portion of the conductive layer 106, which is similar to a, b and e as mentioned above and may be in the range of 0.2 µm to 20 µm. In FIG. 6B, a value of g is a connection width of the top electrode 105 and the conductive layer 106 at the non-connection edge of the top electrode, which is similar to the previously mentioned value of c, and its value is in the range of 0.2 µm-10 µm. As described with reference to FIG. 3, the impedance mismatch interface is generated by providing the conductive layer 106 at the non-connection edge of the electrodes, thereby improving the Q value. However, the improvement effect is related to the thickness of the conductive layer 106 and the width c of the contact portion of the conductive layer with the top electrode. When c is constant, the Q value generally increases at first and then decreases along with the thickness of the conductive layer 106. When the thickness is consistent, the Q value generally increases and decreases periodically along with the change of the value of the width c. On the other hand, the thicker the conductive layer is, the smaller the resistance of the electrode is. Therefore, there is balance required between the thickness of the conductive layer and the resistance of the electrode, such that a relatively suitable thickness of the conductive layer can be selected to limit a further decrease in the electrode loss and a further increase in the Q value. In addition, the bridge structure and/or the wing structure is provided in such a manner that the conductive layer 106 is arranged on the outer side of the effective region. In this way, the influence of the thickness of the conductive layer on the Q value of the resonator reduces, so that an optimal thickness value can be selected to ensure that the electrode loss is further decreased. On the other hand, by means of providing the protruding structure 109 at the edge of the effective region, the Q value can be optimized and improved by selecting proper width and thickness for the protruding structure, and the bridge structure and/or wing structure and the suspended portion of the conductive layer 106 can further form a structure like a tuning fork. Accordingly, secondary resonance can be generated, and more acoustic wave energy is limited in the conductive layer 106 and the bridge structure or wing, thereby further improving the Q value.

A process of manufacturing the bulk acoustic wave resonator shown in FIG. 5 will be briefly described below with reference to FIGS. 7 to 12.

Firstly, the bottom electrode 102 and the piezoelectric layer 104 are formed on the substrate, and the protruding layer 109 and the sacrificial layer 112 are then formed above the piezoelectric layer. After that, the top electrode 105 is deposited, the surface dielectric layer 107 of the top electrode is deposited, and the sacrificial layer 112 for the suspended structure of the conductive layer is deposited.

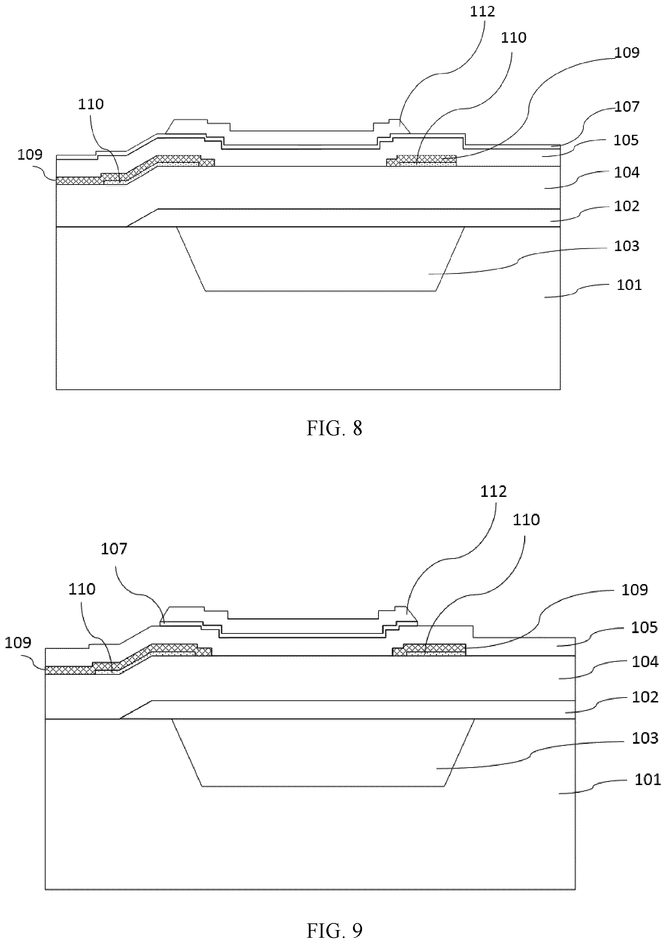

Secondly, the sacrificial layer 112 is patterned by processes such as gluing, exposure, development, and etching to obtain the structure shown in FIG. 8. The etching of the sacrificial layer 112 is stopped on the surface dielectric layer 107 of the top electrode. As shown in FIG. 8, at least part of the patterned sacrificial layer is located in the effective region of the resonator.

Next, the surface dielectric layer 107 of the top electrode is etched and patterned by using the sacrificial layer 112 as a barrier layer, to obtain the structure shown in FIG. 9.

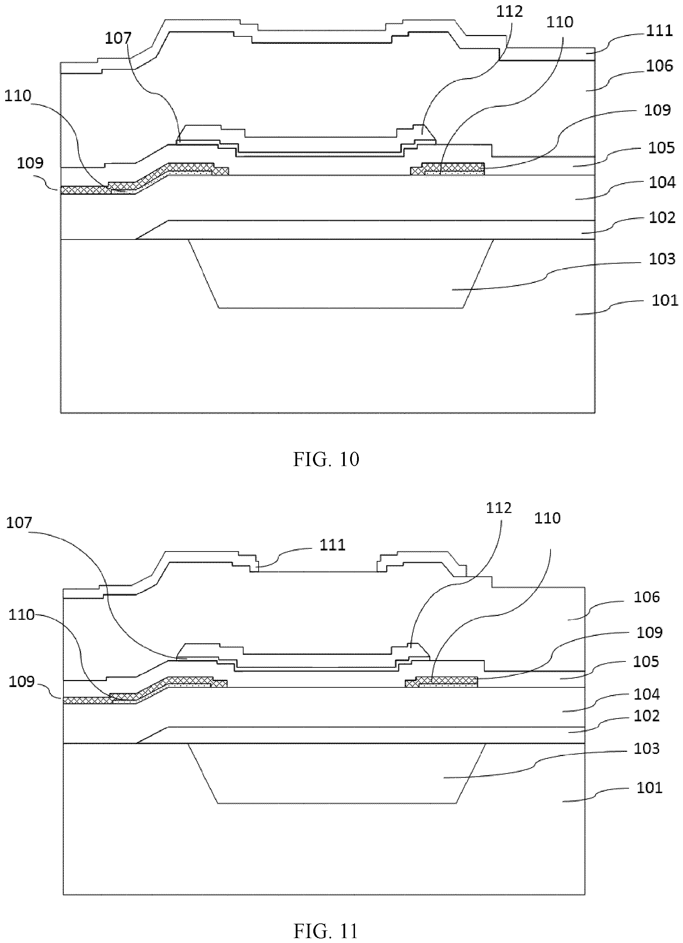

After that, the conductive layer 106 and the surface dielectric layer 111 of the conductive layer are sequentially deposited to obtain the structure shown in FIG. 10. The conductive layer 106 is electrically connected to the top electrode 105.

Afterwards, the surface dielectric layer 111 of the conductive layer is processed and patterned by processes such as gluing, exposure, development, and etching, to obtain the structure shown in FIG. 11. The etching of the surface dielectric layer 111 of the conductive layer is stopped on the conductive layer 106. In FIG. 11, the surface dielectric layer 111 of the conductive layer has a predetermined shape. As shown in FIG. 11, an inner end of the patterned surface dielectric layer 111 of the conductive layer is located on an inner side of a corresponding outer end of the patterned sacrificial layer 112 in the lateral direction of the resonator.

Thereafter, the conductive layer 106 is etched by using the surface dielectric layer 111 of the conductive layer as a barrier layer to obtain the structure shown in FIG. 12.

Finally, the sacrificial layers that include the sacrificial layer 110, the sacrificial layer 112 and the sacrificial layer of the acoustic mirror are removed by wet etching or the like, to obtain the final structure as shown in FIG. 5.

It should be noted that, the above method is merely exemplary. For example, the resonator may not be provided with a wing and a bridge structure, and may not be provided with a protruding structure. In an embodiment, the surface dielectric layer 107 of the top electrode or the surface dielectric layer 111 of the conductive layer may not be provided, but the conductive layer 106 is coated with other patterned material layers.

In addition, as can be understood for the foregoing method, for example, when the surface dielectric layer 111 of the conductive layer is used as a barrier layer, the surface dielectric layer 111 of the conductive layer is not affected by the release of the sacrificial layer 112 after etching the conductive layer 106.

FIGS. 13 to 30 respectively illustrate structures of bulk acoustic wave resonators according to variant embodiments of the present disclosure, which will be specifically described below.

The embodiment shown in FIG. 13 is similar to that of FIG. 3, except that an angle between a lower edge and an inner side surface of the conductive layer 106 is an acute angle in FIG. 13. Whereas in FIG. 3, the side surface of the conductive layer 106 extends in an upright direction or parallel to a thickness direction of the resonator.

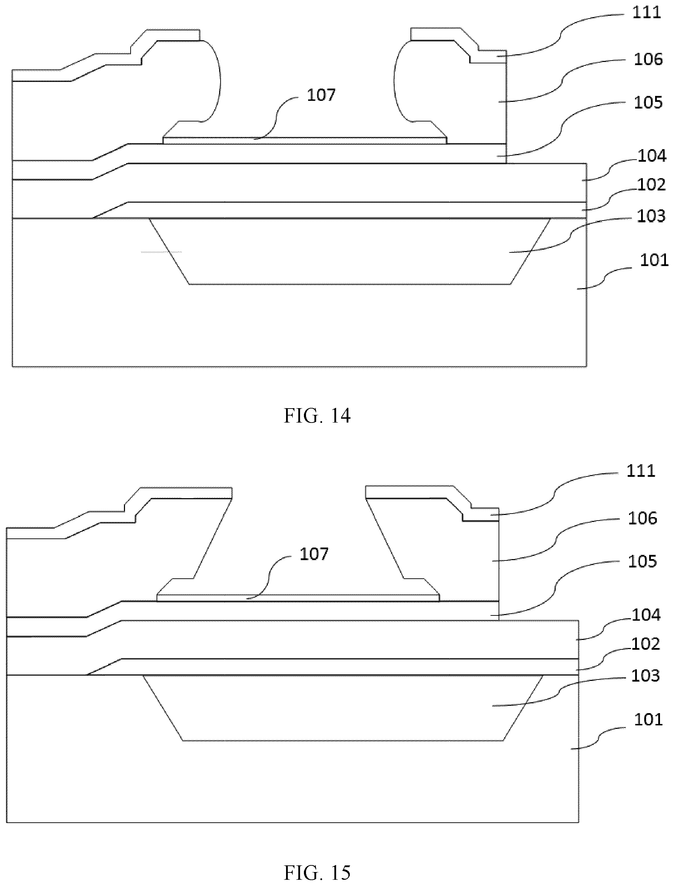

The embodiment shown in FIG. 14 is similar to that of FIG. 3, except that an inner side surface of the conductive layer 106 is arc-shaped in FIG. 14. Whereas in FIG. 3, the side surface of the conductive layer 106 extends in an upright direction or parallel to a thickness direction of the resonator.

The embodiment shown in FIG. 15 is similar to that of FIG. 3, except that an angle between an upper edge and an inner side surface of the conductive layer 106 is an acute angle in FIG. 15. Whereas in FIG. 3, the side surface of the conductive layer 106 extends in an upright direction or parallel to a thickness direction of the resonator.

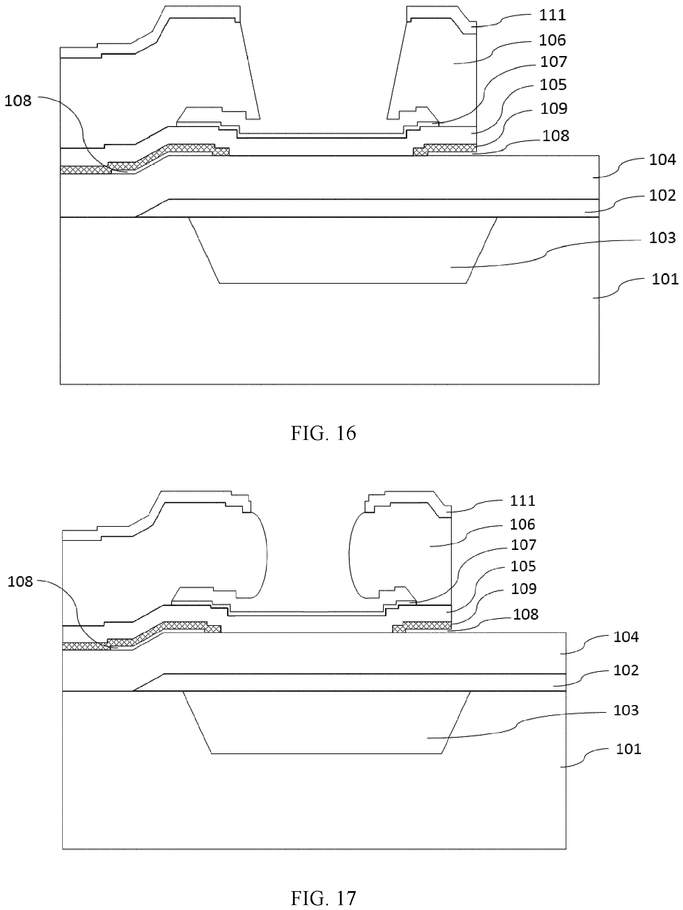

The embodiment shown in FIG. 16 is similar to that of FIG. 5, except that an angle between a lower edge and an inner side surface of the conductive layer 106 is an acute angle in FIG. 16. Whereas in FIG. 5, the side surface of the conductive layer 106 extends in an upright direction or parallel to a thickness direction of the resonator.

The embodiment shown in FIG. 17 is similar to that of FIG. 5, except that an inner side surface of the conductive layer 106 is arc-shaped in FIG. 17. Whereas in FIG. 5, the side surface of the conductive layer 106 extends in an upright direction or parallel to a thickness direction of the resonator.

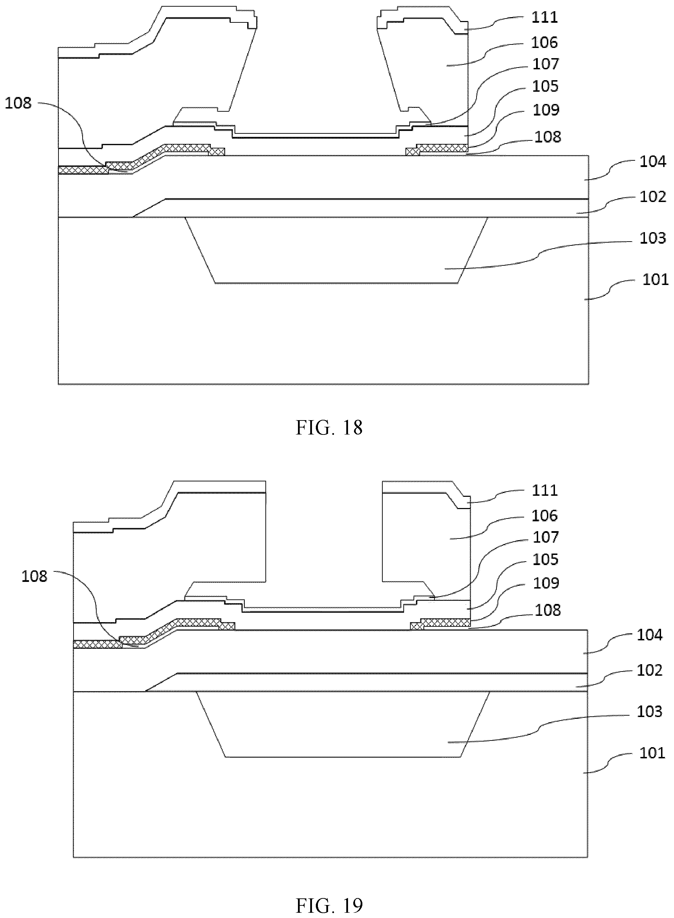

The embodiment shown in FIG. 18 is similar to that of FIG. 5, except that an angle between an upper edge and an inner side surface of the conductive layer 106 is an acute angle in FIG. 18. Whereas in FIG. 5, the side surface of the conductive layer 106 extends in an upright direction or parallel to a thickness direction of the resonator. The embodiment shown in FIG. 19 is similar to that of FIG. 5, except that the conductive layer 106 defines that a bottom surface of the suspended structure does not have a step surface in FIG. 19. Whereas in FIG. 5, the conductive layer 106 defines that the bottom surface of the suspended structure has a step surface. In this case, as can be understood by those skilled in the art, after the sacrificial layer 112 is deposited, a sacrificial layer with a flat surface is formed by a CMP (Chemical Mechanical Polishing) process, and the process of patterning the sacrificial layer is then performed.

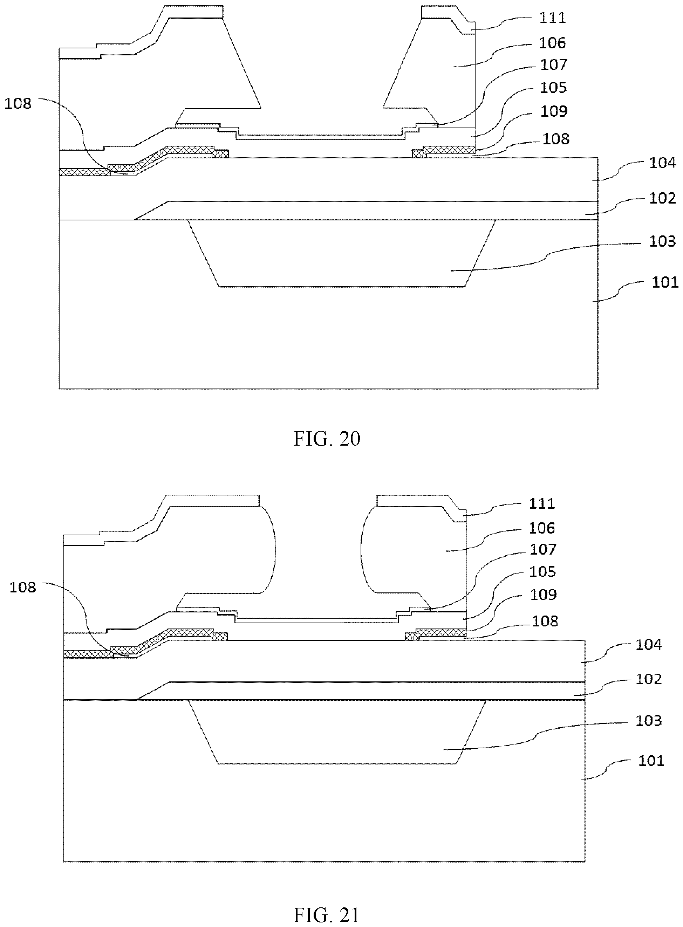

The embodiment shown in FIG. 20 is similar to that of FIG. 19, except that an angle between a lower edge and an inner side surface of the conductive layer 106 is an acute angle in FIG. 20. Whereas in FIG. 19, the side surface of the conductive layer 106 extends in an upright direction or parallel to a thickness direction of the resonator.

The embodiment shown in FIG. 21 is similar to that of FIG. 19, except that an inner side surface of the conductive layer 106 is arc-shaped in FIG. 21. Whereas in FIG. 19, the side surface of the conductive layer 106 extends in an upright direction or parallel to a thickness direction of the resonator.

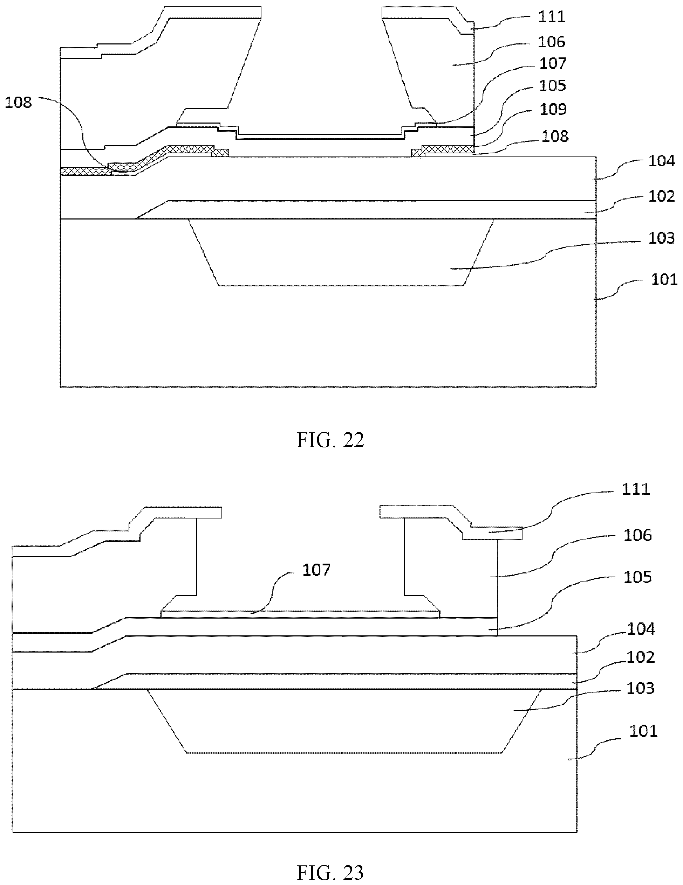

The embodiment shown in FIG. 22 is similar to that of FIG. 19, except that an angle between an upper edge and an inner side surface of the conductive layer 106 is an acute angle in FIG. 22. Whereas in FIG. 19, the side surface of the conductive layer 106 extends in an upright direction or parallel to a thickness direction of the resonator.

The side surface topographies of the suspended structures of the conductive layers 106 shown in FIG. 13 to FIG. 22 may be formed by adjusting the etching process, for example, changing parameters such as a gas ratio and an etching time of dry etching.

The embodiment shown in FIG. 23 is similar to that of FIG. 3, except that in FIG. 23, an inner side of the dielectric layer 111 extends to an inner side of an inner side surface of the conductive layer 106, and the dielectric layer 111 also extends to an outer side of an outer side surface of the conductive layer 106 at the non-connection edge of the top electrode. Whereas in FIG. 3, the inner side of the dielectric layer 111 is flush with the inner side surface of the conductive layer 106, and the outer side of the dielectric layer 111 is flush with the outer side surface of the conductive layer 106 at the non-connection edge of the top electrode.

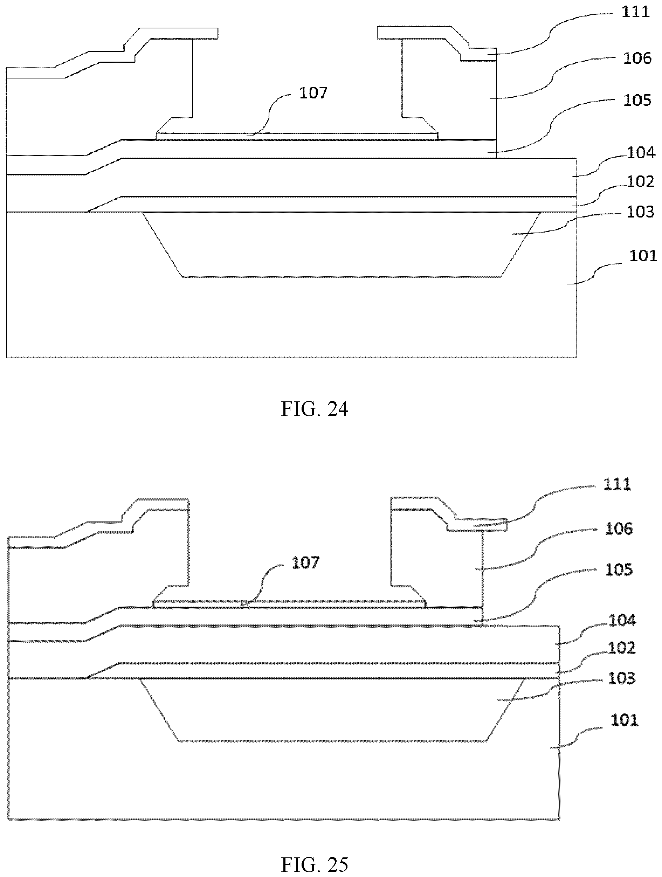

The embodiment shown in FIG. 24 is similar to that of FIG. 3, except that an inner side of the dielectric layer 111 extends to an inner side of an inner side surface of the conductive layer 106 in FIG. 24. Whereas in FIG. 3, the inner side of the dielectric layer 111 is flush with the inner side surface of the conductive layer 106.

The embodiment shown in FIG. 25 is similar to that of FIG. 3, except that in FIG. 25, the dielectric layer 111 also extends to an outer side of an outer side surface of the conductive layer 106 at the non-connection edge of the top electrode. Whereas in FIG. 3, the outer side of the dielectric layer 111 is flush with the outer side surface of the conductive layer 106 at the non-connection edge of the top electrode.

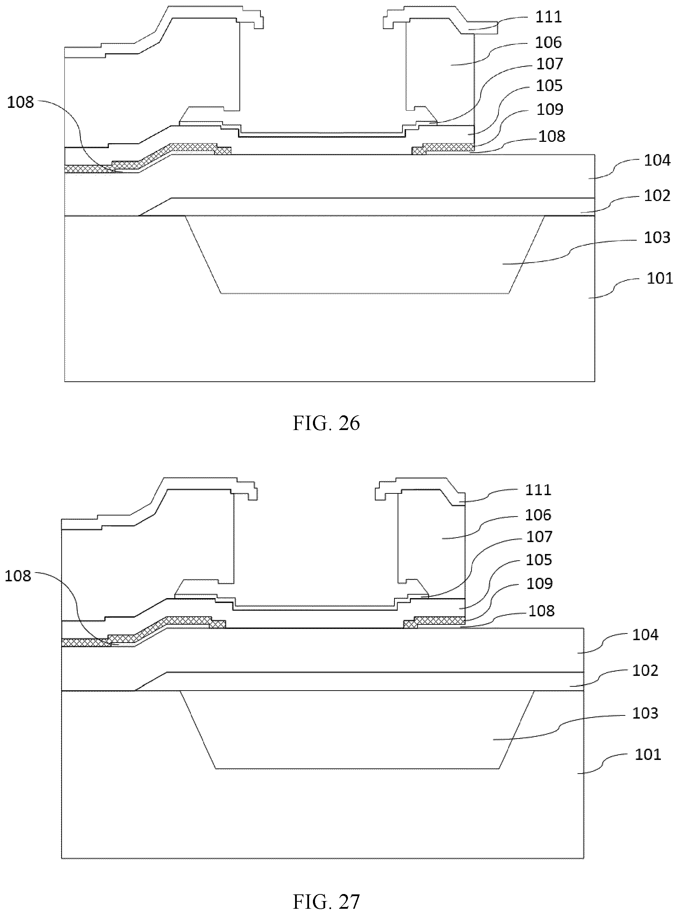

The embodiment shown in FIG. 26 is similar to that of FIG. 5, except that in FIG. 26, an inner side of the dielectric layer 111 extends to an inner side of an inner side surface of the conductive layer 106, and the dielectric layer 111 also extends to an outer side of an outer side surface of the conductive layer 106 at the non-connection edge of the top electrode. Whereas in FIG. 5, the inner side of the dielectric layer 111 is flush with the inner side surface of the conductive layer 106, and the outer side of the dielectric layer 111 is flush with the outer side surface of the conductive layer 106 at the non-connection edge of the top electrode.

The embodiment shown in FIG. 27 is similar to that of FIG. 5, except that an inner side of the dielectric layer 111 extends to an inner side of an inner side surface of the conductive layer 106 in FIG. 27. Whereas in FIG. 5, the inner side of the dielectric layer 111 is flush with the inner side surface of the conductive layer 106.

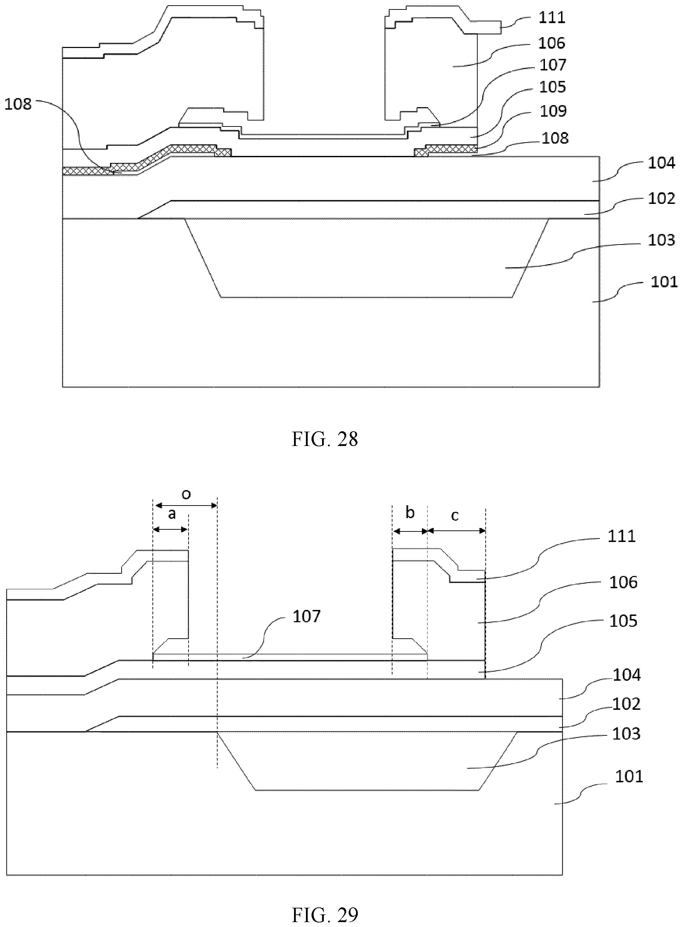

The embodiment shown in FIG. 28 is similar to that of FIG. 5, except that in FIG. 28, the dielectric layer 111 also extends to an outer side of an outer side surface of the conductive layer 106 at the non-connection edge of the top electrode. Whereas in FIG. 5, the outer side of the dielectric layer 111 is flush with the outer side surface of the conductive layer 106 at the non-connection edge of the top electrode.

In the embodiments shown in FIG. 23 to FIG. 28 in which the edge of the dielectric layer 111 is not flush with the conductive layer 106, the forming may be controlled by controlling a lateral rate of etching the conductive layer 106.

The embodiment shown in FIG. 29 is similar to that of FIG. 3, except that at the connection edge of the top electrode in FIG. 29, an outer side edge of the suspended structure is located on an outer side of the acoustic mirror in the lateral direction, and a lateral distance o therebetween may be, for example, in the range of 0.2 µm to 10 µm. Whereas in FIG. 3, at the connection edge of the top electrode, the outer edge of the suspended structure is located on the inner side of the acoustic mirror in the lateral direction.

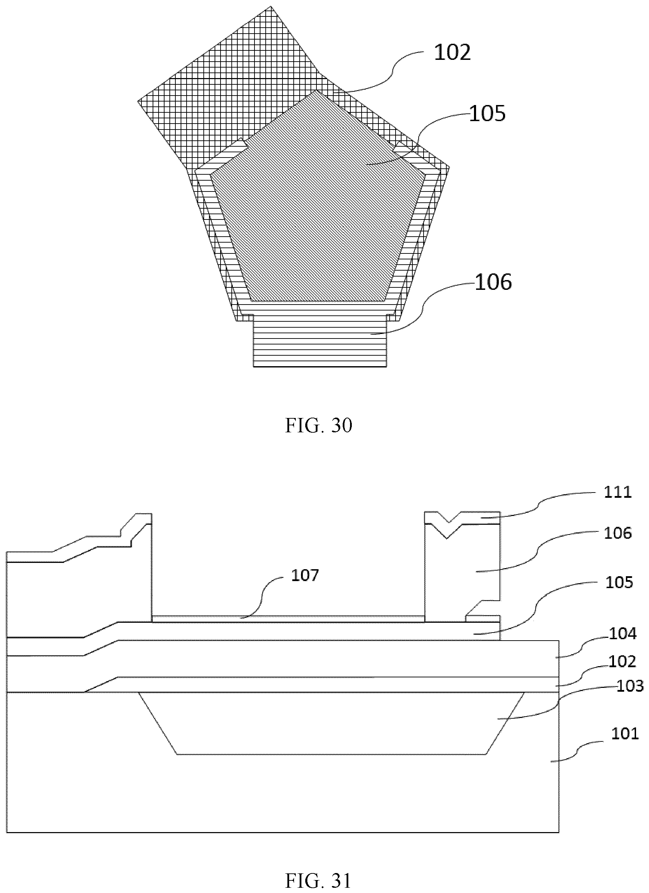

In the embodiment shown in FIG. 30, at the non-connection edge of the top electrode, the conductive portion 106 may be partially disconnected instead of being annularly arranged. In an alternative embodiment, a sum of lengths of disconnected portions is not greater than 90% of a perimeter of the effective region of the entire resonator. The embodiment shown in FIG. 30 may be applied to the embodiments described above with reference to the figures.

In the illustrated embodiments of the present disclosure, the suspended structure is arranged at the inner end of the conductive layer, and is an inner end suspended structure. However, as can be understood by those skilled in the art, the suspended structure may be arranged at the outer end of the conductive layer, and is an outer end suspended structure. A bulk acoustic wave resonator having an outer end suspended structure is exemplarily described below with reference to FIG. 31 to FIG. 37.

FIG. 31 to FIG. 33 are exemplary sectional views of different embodiments similar to the view of the bulk acoustic wave resonator along line B-B' in FIG. 1B. In these figures, 101 indicates a substrate, 102 indicates a bottom electrode, 103 indicates an acoustic mirror, 104 indicates a piezoelectric layer, 105 indicates a top electrode, 106 indicates a conductive layer, 107 indicates a surface dielectric layer of the top electrode, and 111 indicates a surface dielectric layer of the conductive layer.

In FIG. 31, at a non-connection edge of the top electrode, an outer end of the conductive layer is provided with a suspended structure, and a gap is formed between the suspended structure and a surface of the top electrode.

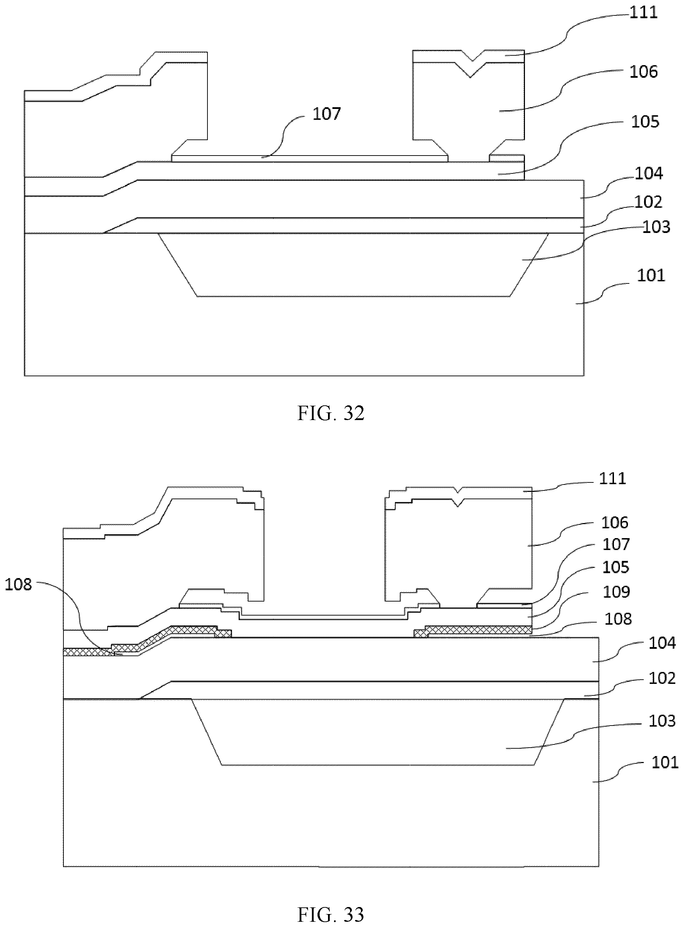

In FIG. 32, the conductive layer is provided with an inner end suspended structure and an outer end suspended structure.

In FIG. 33, unlike that of FIG. 32, the resonator is further provided with a wing, a bridge structure, and a protrusion.

The function of the outer end suspended structure of the conductive layer is similar to that of the inner end suspended structure described above. When the inner end suspended structure and the outer end suspended structure are both provided, two cantilever beams further generate resonance, so as to cooperatively work to improve the Q value of the resonator.

In addition, a side wall of the outer end suspended structure of the conductive layer may has a similar profile to that of the side wall of the inner end suspended structure shown in FIG. 13 to FIG. 22. A positional relationship between the dielectric layer 111 on a top layer of the outer end suspended structure relative and the conductive layer 106 may have an uneven end surface as shown in FIG. 23 to FIG. 28.

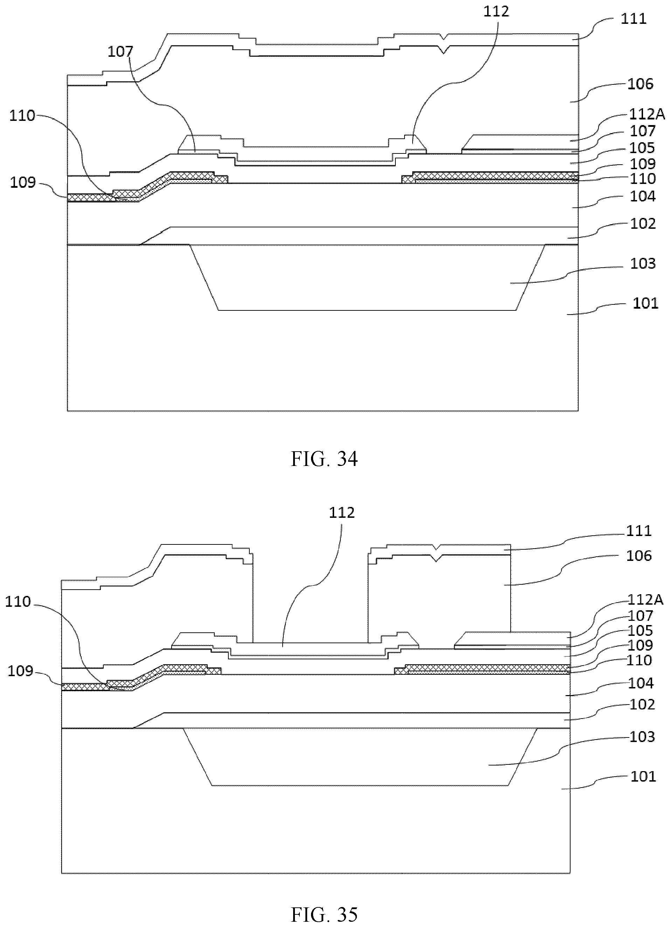

A process of manufacturing the resonator shown in FIG. 33 will be described below with reference to FIG. 34 to 37.

Firstly, the structure shown in FIG. 7 is formed, and the sacrificial layer 112 is then formed and patterned similar to that of FIG. 8. Unlike FIG. 8, an outer sacrificial layer 112A is further arranged on the same layer as the sacrificial layer 112, and the outer sacrificial layer 112Ais located on the outer side of the sacrificial layer 112 and spaced apart from the sacrificial layer 112. After that, similar to FIG. 10, a conductive material layer and a surface dielectric material layer of the conductive layer are provided to form the structure shown in FIG. 34.

Thereafter, similar to FIG. 11, the surface dielectric material layer of the conductive layer is patterned to form the surface dielectric layer 111 of the conductive layer. Among all the conductive material layers, the conductive material layers, which are not covered by the surface dielectric layer 111 of the conductive layer (which is used as a first barrier layer for etching), are removed, for example, in an etching manner, so as to form the conductive layer 106. In the removing process, the conductive material layer above the sacrificial layer 112 is removed, and the conductive material layer above the outer sacrificial layer 112A, which is located on the outer side of the conductive layer, is also removed. In other words, the etching process is stopped at the sacrificial layer 112 and the outer sacrificial layer 112A during the removing process. Finally, the structure as shown in FIG. 35 is formed.

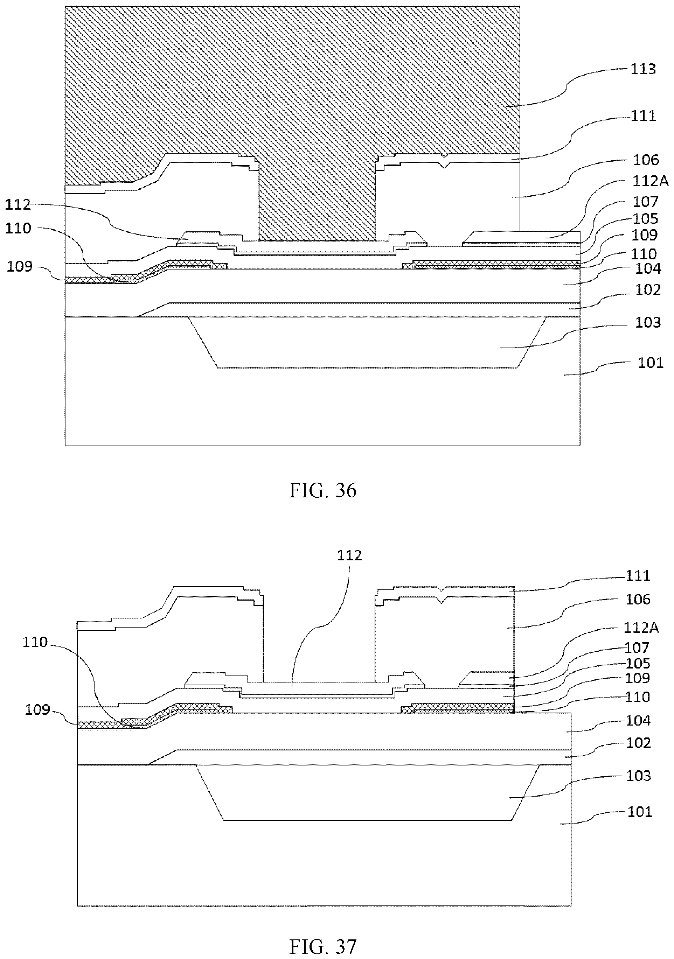

After that, as shown in FIG. 36, photoresist 113 is provided to be used as a second etching barrier layer. The photoresist 113 covers the surface dielectric layer 111 of the conductive layer and the exposed sacrificial layer 112, but does not cover the exposed outer sacrificial layer 112A.

Then, etching is performed to remove the outer sacrificial layer 112A, which is located on the outer side of the conductive layer 106. The top electrode material layer located on the outer side of the conductive layer 106 is removed to form the top electrode 105, so as to form the structure shown in FIG. 37.

Finally, the sacrificial layer 112, the outer sacrificial layer 112A and the sacrificial layer 110 for forming the wing and the bridge structure are released to form the resonator structure shown in FIG. 33.

It should be noted that, in the present disclosure, various numerical ranges, except for explicitly indicating that the endpoint value is not included, may be an endpoint value, or may be a median value of the numerical ranges, and these are all within the scope of the present disclosure.

In the present disclosure, the top and bottom are described with respect to the bottom surface of the substrate of the resonator. As for a component, a side close to the bottom surface is a lower side, and a side away from the bottom surface is an upper side.

In the present disclosure, the inside and outside are orientated in a lateral direction or a radial direction with respect to the center of the effective region of the resonator. A side or an end of a component close to the center is an inner side or inner end, and a side or an end of the component away from the center is an outer side or outer end. A position located on an inner side of a reference position indicates that this position is located between the reference position and the center in the lateral direction or radial direction, and a position located on an outer side of the reference position indicates that this position is located farther away from the center in the lateral direction or radial direction.

As can be understood by those skilled in the art, the bulk acoustic wave resonator according to the present disclosure may be used to form a filter or an electronic device.

The electronic device herein may include, but is not limited to, intermediate products such as a radio-frequency front end, and a filtering and amplifying module, and terminal products such as mobile phones, WIFI, and drones.

Based on the above description, the present disclosure provides the following technical solutions.
1. A bulk acoustic wave resonator includes:
   a substrate;
   an acoustic mirror;
   a bottom electrode;
   a top electrode; and
   a piezoelectric layer,
   wherein
   the acoustic mirror, the bottom electrode, the piezoelectric layer and the top electrode overlap with each other in a thickness direction of the resonator to form an overlapping region, and the overlapping region is an effective region of the resonator;
   a conductive layer is provided on an upper side of the top electrode and surrounds an edge of the effective region, and the conductive layer is electrically connected to the top electrode; and
   a bottom surface of at least part of an inner end and/or an outer end of the conductive layer is spaced apart from an upper surface of the top electrode by a gap, and the gap forms a suspended structure.
2. The resonator according to 1, wherein
   the suspended structure is disposed at a connection edge of the top electrode and/or a non-connection edge of the top electrode.
3. The resonator according to 2, wherein
   the suspended structure is an annular suspended structure; or
   the suspended structure is disposed at the connection edge of the top electrode and a part of the non-connection edge of the top electrode.
4. The resonator according to 3, wherein
   the suspended structure is disposed intermittently at the non-connection edge of the top electrode, and a sum of lengths of disconnected potions is equal to or less than 90% of a perimeter of the effective region of the entire resonator.
5. The resonator according to 1, wherein
   the suspended structure has a width in a range of 0.2 µm to 20 µm.
6. The resonator according to any one of 1-5, wherein
   the suspended structure is disposed at the non-connection edge of the top electrode, and a width of a contact portion of the conductive layer with the non-connection edge is in a range of 0.2 µm to 10 µm.
7. The resonator according to any one of 1-6 further includes:
   an inner end suspended structure provided at the connection edge of the top electrode, the inner end suspended structure being formed on the inner end of the conductive layer, and a lateral distance between an outer edge of the gap of the inner end suspended structure and an edge of the acoustic mirror is in a range of 0.2 µm to 10 µm.
8. The resonator according to 7, wherein
   the outer edge of the gap of the inner end suspended structure is located on an inner side of the edge of the acoustic mirror in a lateral direction of the resonator; or
   the outer edge of the gap of the inner end suspended structure is located on an outer side of the edge of the acoustic mirror in a lateral direction of the resonator.
9. The resonator according to any one of 1-7, wherein
   the top electrode is provided with a bridge structure at the connection edge of the top electrode, and/or the top electrode is provided with a wing at the non-connection edge of the top electrode;
   an inner edge of the bridge structure and/or the wing structure is located on an inner side of the effective region; and/or
   the top electrode further includes a protruding structure, and the protruding structure is disposed at least around the inner edge of the bridge structure and/or the wing structure.
10. The resonator according to 9, wherein
   the top electrode is provided with an inner end suspended structure, and the inner end suspended structure is formed on the inner end of the conductive layer; and
   in the lateral direction, the inner edge of the wing and/or the bridge structure is located on an inner side of the outer edge of the gap of the inner end suspended structure or flush with the outer edge of the gap of the inner end suspended structure.
11. The resonator according to 10, wherein
   in the lateral direction, a distance between the inner edge of the wing structure or bridge structure and the outer edge of the gap of the inner end suspended structure is in a range of 0.2 µm to 10 µm.
12. The resonator according to any one of 1-11, wherein
   the inner end suspended structure or the outer end suspended structure of the conductive layer has a side surface, which is parallel to the thickness direction of the resonator or forms an angle relative to the thickness direction, or the inner end of the conductive layer and/or a side surface of the outer end suspended structure includes an arc surface.
13. The resonator according to 1 further includes:
   a non-conductive dielectric layer provided on the upper surface of the top electrode and/or an upper surface of the conductive layer.
14. The resonator according to 13, wherein
   at a connection edge and/or a non-connection edge of the top electrode, an inner end of the non-conductive dielectric layer of the conductive layer extends to an inner side of the conductive layer; and/or
   at a non-connection edge of the top electrode, an outer end of the non-conductive dielectric layer of the conductive layer extends to an outer side of the conductive layer.
15. The resonator according to 13, wherein
   the connection edge of the top electrode is provided with an inner end suspended structure, and the inner end suspended structure is formed on the inner end of the conductive layer; and
   an inner end of the non-conductive dielectric layer of the top electrode is located on an inner side of the outer edge of the gap of the inner end suspended structure in the lateral direction.
16. The resonator according to 1, wherein
   the conductive layer has a bottom surface defining the suspended structure, and the bottom surface of the conductive layer includes a step surface and/or a horizontal surface.
17. A filter includes the resonator according to any one of 1-16.
18. An electronic device includes the filter according to 17 or the resonator according to any one of 1-16.
19. A method of manufacturing a bulk acoustic wave resonator, wherein
   the method includes the steps of:
   forming, on a substrate, a stacked structure of a bottom electrode, a piezoelectric layer, and a top electrode material layer;
   the method further includes:
      step 1, forming and patterning a sacrificial layer on the stacked structure;
      step 2, forming a conductive material layer that covers the patterned sacrificial layer and the top electrode material layer, the conductive material layer being electrically connected to the top electrode material layer;
      step 3, providing and patterning a barrier layer on the conductive material layer, an inner end of the patterned barrier layer being located on an inner side of a corresponding outer end of the sacrificial layer in a lateral direction of the resonator;
      step 4, removing a portion of the conductive material layer that is not covered by the patterned barrier layer and removing the top electrode material layer, to form a conductive layer and a top electrode; and
      step 5, releasing the sacrificial layer to form a gap between a bottom surface of an inner end of the conductive layer and an upper surface of the top electrode, to form an inner end suspended structure,
   wherein the resonator includes an acoustic mirror, an overlapping region of the acoustic mirror, the top electrode, the piezoelectric layer and the bottom electrode in a thickness direction of the resonator forms an effective region of the resonator, and in step 4, the conductive layer is disposed around an edge of the effective region.
20. The method according to 19, wherein
   in step 3, the barrier layer is a non-conductive dielectric layer of the conductive layer.
21. The method according to 19, wherein
   the non-conductive dielectric layer of the top electrode is arranged on the upper surface of the top electrode material layer; and
   after step 1 and before step 2, the method further includes:
      step 1A, configuring the patterned sacrificial layer as a barrier layer, and removing a portion of the non-conductive dielectric layer of the top electrode that is not covered by the patterned sacrificial layer.
22. The method according to 19, wherein
   the top electrode is provided with a bridge structure at a connection edge of the top electrode, and/or the top electrode is provided with a wing at a non-connection edge of the top electrode; and
   in step 1, in the lateral direction of the resonator, an inner edge of the bridge structure and/or the wing is located on an inner side of an outer end of the patterned sacrificial layer or is flush with an outer end of the patterned sacrificial layer.
23. The method according to 19, wherein
   in step 1, the patterned sacrificial layer includes a first sacrificial layer portion and a second sacrificial layer portion, the second sacrificial layer portion is spaced apart from the first sacrificial layer portion in the lateral direction and is located on an outer side of the first sacrificial layer portion, and the first sacrificial layer portion is configured to form the inner end suspended structure;
   in step 3, the barrier layer is a first barrier layer;
   the step 4 includes:
      step 41, removing a portion of the conductive material layer that is not covered by the patterned first barrier layer, to form the conductive layer, wherein in step 41, a portion of the conductive material layer above the first sacrificial layer portion is removed, and a portion of the conductive material layer above the second sacrificial layer portion on the outer side of the conductive layer is removed;
      step 42, providing a second barrier layer, the second barrier layer covering the patterned first barrier layer and a portion of the first sacrificial layer that is exposed by removing the conductive material layer; and
      step 43, removing the top electrode material layer and a portion of the second sacrificial layer on the outer side of the conductive layer, to form the top electrode; and
   step 5 includes releasing the first sacrificial layer portion to form the inner end suspended structure, and releasing the remaining portion of the second sacrificial layer to form the outer end suspended structure.

Although the embodiments of the present disclosure have been shown and described, it will be understood by those of ordinary skilled in the art that changes may be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic mirror;
a bottom electrode;
a top electrode; and
a piezoelectric layer,
wherein the acoustic mirror, the bottom electrode, the piezoelectric layer and the top electrode overlap with each other in a thickness direction of the resonator to form an overlapping region, and the overlapping region is an effective region of the resonator;
wherein a conductive layer is provided on an upper side of the top electrode and surrounds an edge of the effective region, and the conductive layer is electrically connected to the top electrode; and
wherein a bottom surface of at least part of an inner end and/or an outer end of the conductive layer is spaced apart from an upper surface of the top electrode by a gap, and the gap forms a suspended structure.

2. The resonator according to claim 1, wherein the suspended structure is disposed at a connection edge of the top electrode and/or a non-connection edge of the top electrode.

3. The resonator according to claim 2, wherein the suspended structure is an annular suspended structure; or
the suspended structure is disposed at the connection edge of the top electrode and a part of the non-connection edge of the top electrode.

4. The resonator according to claim 3, wherein the suspended structure is disposed intermittently at the non-connection edge of the top electrode, and a sum of lengths of disconnected potions is equal to or less than 90% of a perimeter of the effective region of the entire resonator.

5. The resonator according to claim 1, wherein the suspended structure has a width in a range of 0.2 µm to 20 µm.

6. The resonator according to any one of claims 1-5, wherein the suspended structure is disposed at the non-connection edge of the top electrode, and a width of a contact portion of the conductive layer with the non-connection edge is in a range of 0.2 µm to 10 µm.

7. The resonator according to any one of claims 1-6, further comprising:
an inner end suspended structure provided at the connection edge of the top electrode, the inner end suspended structure being formed on the inner end of the conductive layer, and a lateral distance between an outer edge of the gap of the inner end suspended structure and an edge of the acoustic mirror is in a range of 0.2 µm to 10 µm.

8. The resonator according to claim 7, wherein the outer edge of the gap of the inner end suspended structure is located on an inner side of the edge of the acoustic mirror in a lateral direction of the resonator; or
the outer edge of the gap of the inner end suspended structure is located on an outer side of the edge of the acoustic mirror in a lateral direction of the resonator.

9. The resonator according to any one of claims 1-7, wherein the top electrode is provided with a bridge structure at the connection edge of the top electrode, and/or the top electrode is provided with a wing at the non-connection edge of the top electrode;
an inner edge of the bridge structure and/or the wing structure is located on an inner side of the effective region; and/or
the top electrode further comprises a protruding structure, and the protruding structure is disposed at least around the inner edge of the bridge structure and/or the wing structure.

10. The resonator according to claim 9, wherein the top electrode is provided with an inner end suspended structure, and the inner end suspended structure is formed on the inner end of the conductive layer; and
in the lateral direction, the inner edge of the wing structure and/or the bridge structure is located on an inner side of the outer edge of the gap of the inner end suspended structure or is flush with the outer edge of the gap of the inner end suspended structure.

11. The resonator according to claim 10, wherein in the lateral direction, a distance between the inner edge of the wing structure or bridge structure and the outer edge of the gap of the inner end suspended structure is in a range of 0.2 µm to 10 µm.

12. The resonator according to any one of claims 1-11, wherein the inner end suspended structure or the outer end suspended structure of the conductive layer has a side surface, which is parallel to the thickness direction of the resonator or forms an angle relative to the thickness direction, or the inner end of the conductive layer and/or a side surface of the outer end suspended structure comprises an arc surface.

13. The resonator according to claim 1, further comprising:
a non-conductive dielectric layer provided on the upper surface of the top electrode and/or an upper surface of the conductive layer.

14. The resonator according to claim 13, wherein at a connection edge and/or a non-connection edge of the top electrode, an inner end of the non-conductive dielectric layer of the conductive layer extends to an inner side of the conductive layer; and/or
at a non-connection edge of the top electrode, an outer end of the non-conductive dielectric layer of the conductive layer extends to an outer side of the conductive layer.

15. The resonator according to claim 13, wherein the connection edge of the top electrode is provided with an inner end suspended structure, and the inner end suspended structure is formed on the inner end of the conductive layer; and
in the lateral direction, an inner end of the non-conductive dielectric layer of the top electrode is located on an inner side of the outer edge of the gap of the inner end suspended structure.

16. The resonator according to claim 1, wherein the conductive layer has a bottom surface defining the suspended structure, and the bottom surface of the conductive layer comprises a step surface and/or a horizontal surface.

17. A filter, comprising the resonator according to any one of claims 1-16.

18. An electronic device, comprising the filter according to claim 17 or the resonator according to any one of claims 1-16.

19. A method of manufacturing a bulk acoustic wave resonator, comprising:
forming, on a substrate, a stacked structure of a bottom electrode, a piezoelectric layer, and a top electrode material layer;
step 1, forming and patterning a sacrificial layer on the stacked structure;
step 2, forming a conductive material layer that covers the patterned sacrificial layer and the top electrode material layer, the conductive material layer being electrically connected to the top electrode material layer;
step 3, providing and patterning a barrier layer on the conductive material layer, an inner end of the patterned barrier layer being located on an inner side of a corresponding outer end of the sacrificial layer in a lateral direction of the resonator;
step 4, removing a portion of the conductive material layer that is not covered by the patterned barrier layer and removing the top electrode material layer, to form a conductive layer and a top electrode; and
step 5, releasing the sacrificial layer to form a gap between a bottom surface of an inner end of the conductive layer and an upper surface of the top electrode, to form an inner end suspended structure,
wherein the resonator comprises an acoustic mirror, an overlapping region of the acoustic mirror, the top electrode, the piezoelectric layer and the bottom electrode in a thickness direction of the resonator forms an effective region of the resonator, and in step 4, the conductive layer is disposed around an edge of the effective region.

20. The method according to claim 19, wherein in step 3, the barrier layer is a non-conductive dielectric layer of the conductive layer.

21. The method according to claim 19, wherein the non-conductive dielectric layer of the top electrode is arranged on the upper surface of the top electrode material layer; and
after step 1 and before step 2, the method further comprises:
step 1A, configuring the patterned sacrificial layer as a barrier layer, and removing a portion of the non-conductive dielectric layer of the top electrode that is not covered by the patterned sacrificial layer.

22. The method according to claim 19, wherein the top electrode is provided with a bridge structure at a connection edge of the top electrode, and/or the top electrode is provided with a wing at a non-connection edge of the top electrode; and
in step 1, in the lateral direction of the resonator, an inner edge of the bridge structure and/or the wing is located on an inner side of an outer end of the patterned sacrificial layer or is flush with an outer end of the patterned sacrificial layer.

23. The method according to claim 19, wherein in step 1, the patterned sacrificial layer comprises a first sacrificial layer portion and a second sacrificial layer portion, the second sacrificial layer portion is spaced apart from the first sacrificial layer portion in the lateral direction and is located on an outer side of the first sacrificial layer portion, and the first sacrificial layer portion is configured to form the inner end suspended structure;
in step 3, the barrier layer is a first barrier layer;
the step 4 comprises:
step 41, removing a portion of the conductive material layer that is not covered by the patterned first barrier layer, to form the conductive layer, wherein in step 41, a portion of the conductive material layer above the first sacrificial layer portion is removed, and a portion of the conductive material layer above the second sacrificial layer portion on the outer side of the conductive layer is removed;
step 42, providing a second barrier layer, the second barrier layer covering the patterned first barrier layer and a portion of the first sacrificial layer that is exposed by removing the conductive material layer; and
step 43, removing the top electrode material layer and a portion of the second sacrificial layer on the outer side of the conductive layer, to form the top electrode; and
step 5 comprises releasing the first sacrificial layer portion to form the inner end suspended structure, and releasing the remaining portion of the second sacrificial layer to form the outer end suspended structure.
